Europäisches Patentamt

European Patent Office

Office européen des brevets

(19)

(11) Numéro de publication : **0 500 414 A1**

(12) # DEMANDE DE BREVET EUROPEEN

(21) Numéro de dépôt : **92400337.9**

(22) Date de dépôt : **10.02.92**

(51) Int. Cl.$^5$ : **B29C 71/04,** B29C 59/16

(30) Priorité : **12.02.91 FR 9101602**

(43) Date de publication de la demande :
**26.08.92 Bulletin 92/35**

(84) Etats contractants désignés :
**BE DE GB IT NL**

(71) Demandeur : **COMMISSARIAT A L'ENERGIE ATOMIQUE**
**31-33, rue de la Fédération**
**F-75015 Paris (FR)**

(71) Demandeur : **CENTRE NATIONAL DE LA RECHERCHE SCIENTIFIQUE (CNRS)**
**15, Quai Anatole France**
**F-75700 Paris Cedex 07 (FR)**

(72) Inventeur : **Lecayon, Gérard**
**33 La Vaucouleur**
**F-91940 Les Ulis (FR)**
Inventeur : **Tourillon, Gérard**
**2Bis, rue de Frileuse**
**F-91440 Bures sur Yvette (FR)**
Inventeur : **Viel, Pascal**
**1 Avenue du Maréchal Joffre**
**F-92190 Meudon (FR)**

(74) Mandataire : **Mongrédien, André et al**
**c/o BREVATOME 25, rue de Ponthieu**
**F-75008 Paris (FR)**

(54) **Procédé pour modifier les propriétés de conductivité électrique d'un polymère organique par irradiation au moyen d'un rayonnement synchrotron.**

(57) L'invention concerne un procédé pour modifier les propriétés de conductivité électrique d'un polymère organique par irradiation au moyen d'un rayonnement synchrotron.

Selon ce procédé, on irradie au moins certaines parties d'un film (7) par le faisceau blanc du rayonnement provenant d'un synchrotron (1). Lorsque le polymère est conducteur, par exemple du polyoctylthiophène, il devient progressivement isolant. En revanche, lorsque le polymère est isolant comme dans le cas du polyacrylonitrile, il devient progressivement conducteur.

Dans les deux cas, on peut contrôler le degré de modification en réglant les conditions d'irradiation, notamment la durée.

FIG. 1

EP 0 500 414 A1

La présente invention a pour objet un procédé de modification des propriétés de conductivité électrique d'un polymère organique, utilisable en particulier en micro-électronique.

En micro-électronique, il est d'un grand intérêt de disposer de techniques permettant de faire évoluer les propriétés électriques d'un film de l'état isolant à l'état conducteur ou inversement, pour réaliser en particulier des circuits submicroniques. Pour la réalisation de tels circuits, les techniques d'irradiation telles que la photolithographie, se révèlent particulièrement intéressantes, car elles permettent de définir par irradiation d'un photorésist les zones constituant le circuit et de réaliser ensuite celui-ci par gravure d'un substrat approprié.

Toutefois, l'inconvénient de ces techniques de photolithographie est de nécessiter l'emploi d'un film polymère intermédiaire qui joue le rôle de photorésist et qui devra être éliminé en fin d'opération.

Aussi, les recherches récentes ont porté sur les moyens de réaliser un circuit conducteur submicronique sur un substrat isolant sans recourir à l'étape intermédiaire de dépôt d'une couche et de résines jouant le rôle de photorésist.

Parmi ces techniques, on connait un procédé qui permet de réaliser par irradiation au moyen de faisceau d'ions de haute énergie un film comportant dans son épaisseur une structure constituée successivement soit d'une couche isolante, d'une couche à caractère semi-métallique et d'une couche isolante, soit d'une couche semi-métallique, d'une couche isolante et d'une couche semi-métallique, (voir la demande internationale W0-88/02692). Dans ce procédé, il est nécessaire que les ions traversent le substrat pour obtenir la structure à trois couches et il est difficile de former sur un substrat isolant le dessin d'un circuit conducteur. Ainsi, il est impossible d'utiliser un tel procédé sur une structure multicouche pour modifier seulement la couche supérieure.

La présente invention a précisément pour objet un procédé de modification des propriétés de conductivité électrique d'un polymère organique qui permet de faire passer ce polymère graduellement de l'état isolant à l'état conducteur ou inversement, en utilisant une technique d'irradiation sans dépôt de photorésist pour définir des circuits qui peuvent être submicroniques.

Selon l'invention, le procédé pour modifier les propriétés de conductivité électrique d'un polymère organique consiste à irradier au moins certaines parties d'un film de ce polymère par le faisceau blanc du rayonnement synchrotron.

On rappelle que le faisceau blanc du rayonnement synchrotron est le faisceau issu d'un synchrotron avant monochromatisation ; celui-ci comprend un rayonnement analogue au visible enrichi en ultraviolets et en rayons X mous dont les longueurs d'onde vont de 2 à quelques milliers d'Angströms.

On a découvert selon l'invention qu'en irradiant un polymère conducteur avec un tel rayonnement, on pouvait le faire passer graduellement à l'état isolant, et qu'en irradiant un polymère isolant avec ce même rayonnement, on pouvait le transformer graduellement en polymère conducteur de l'électricité ; de plus, l'utilisation de ce rayonnement permet d'obtenir la conductivité électrique voulue en jouant notamment sur la durée d'irradiation par le faisceau blanc synchrotron et de réaliser les transformations avec un degré de résolution élevé sous la forme de traces dont les formes peuvent être pilotées à volonté.

Cet effet du faisceau blanc du rayonnement synchrotron sur des polymères organiques, isolants ou conducteurs, n'a jamais été mis en évidence jusqu'à présent.

En effet, on a seulement utilisé le rayonnement synchrotron en micro-électronique, pour le dépôt en phase vapeur de films de nitrure de silicium contenant de l'hydrogène ou pour la gravure de silicium (voir J. Vac. Sci. Technon. D 5 (5), 1987, p. 1436-1440 et J. Appl. Phys. 61(5), 1987, p. 2035 à 2037), pour le dépôt de molybdène (voir Appl. Phys. Lett. 55(10), 1989, p. 1020-1022), ou pour le dépôt de carbone (voir Appl. Phys. Lett. 55(16), 1989, p. 1644-1646).

On a aussi étudié l'irradiation par les rayons X mous d'un rayonnement synchrotron de couches de polytétrafluoroèthylène utilisées en photolithographie, et on a constaté que ce rayonnement réticulait le polytétrafluoroéthylène (voir Beam Line U3-C p. 76 et 81).

Ainsi, jusqu'à présent, on n'a jamais utilisé ce rayonnement pour modifier la conductivité électrique d'un polymère et ceci de façon contrôlée.

Selon un premier mode de réalisation de l'invention, le polymère de départ est conducteur de l'électricité et on diminue sa conductivité par irradiation au moyen du faisceau blanc du rayonnement synchrotron.

Les polymères conducteurs utilisables dans ce premier mode de réalisation de l'invention sont les polypyrroles, les polythiophènes, par exemple les polyalkyl thiophènes, ou tout autre polymère organique conducteur.

Avec ces polymères conducteurs dopés, l'irradiation par le faisceau blanc du rayonnement synchrotron provoque un dédopage du polymère qui le transforme progressivement en polymère isolant. On peut donc jouer sur la durée d'irradiation pour obtenir les états intermédiaires entre l'état conducteur de départ et l'état isolant.

Selon un second mode de réalisation de l'invention, le polymère de départ est isolant électrique et on augmente sa conductivité électrique par irradiation au moyen du faisceau blanc du rayonnement synchrotron.

2

Les polymères isolants, susceptibles de devenir conducteurs sous l'effet de cette irradiation, sont en particulier des polymères isolants à groupes pendants qui peuvent être éliminés par irradiation, ce qui conduit à la formation de structures cyclisées et éventuellement de double liaisons dans la chaîne du polymère.

Ces groupes pendants peuvent être par exemple des groupes nitrile, ester, aldéhyde et pyridine. A titre d'exemple d'un tel polymère isolant, on peut citer le polyacrylonitrile.

Dans les deux modes de réalisation du procédé de l'invention, on peut régler l'augmentation ou la diminution de conductivité électrique du polymère soumis au traitement en contrôlant les conditions d'irradiation, en particulier la durée d'irradiation.

Ainsi, le procédé de l'invention est très intéressant puisqu'il permet de passer graduellement d'une structure isolante à une structure conductrice ou inversement. De plus, comme la modification se limite à la zone d'impact du faisceau synchrotron, on peut réaliser des modifications uniquement sur certaines zones d'un substrat dont la forme et les dimensions sont bien définies, par exemple des stries, en jouant sur l'épaisseur de la fente de sortie du faisceau, sur le diamètre du diaphragme et sur le mode de déplacement (vitesse et direction) imposé au faisceau et/ou au film de polymère soumis au traitement.

De préférence, les films de polymère soumis à ce traitement ont une structure homogène et sont sous la forme d'une couche mince ayant par exemple une épaisseur allant de 1 nm à 50 μm.

Les films, notamment ceux d'épaisseur très faible, peuvent être préparés par électropolymérisation du monomère ou d'un mélange de monomères appropriés sur un substrat conducteur de l'électricité. Dans ce procédé, le substrat conducteur joue le rôle de cathode et il est immergé dans une solution du monomère ou du mélange de monomères dans un solvant organique approprié contenant un électrolyte support, par exemple du perchlorate de tétraéthyl-éthylammonium. Le solvant utilisé peut être l'acétonitrile ou un autre solvant aprotique dipolaire dans lequel le polymère formé est insoluble/ et la concentration en monomères de la solution est généralement dans la gamme allant de $10^{-1}$ mol/l à 10 mol/l. Dans certains cas, on peut utiliser le monomère sans solvant lorsque celui-ci est liquide à la température ambiante. Pour réaliser l'électropolymérisation, on applique une polarisation cathodique sur la surface du substrat conducteur, la tension appliquée dépendant en particulier du monomère à polymériser et la durée de polarisation permettant de contrôler l'épaisseur du film.

On peut aussi préparer les films à partir d'une solution du polymère dans un solvant approprié, en déposant cette solution sur un substrat et en évaporant ensuite le solvant. Dans ce cas, on contrôle l'épaisseur du film en jouant sur la concentration en polymère de la solution et sur la quantité de solution déposée sur le substrat.

On peut mettre en oeuvre le procédé de l'invention sur un film unique ou sur un ensemble constitué de plusieurs films de polymère superposés. Dans ce cas, on préfère qu'au moins deux films de l'ensemble soient réalisés en des polymères différents ayant un comportement différent lorsqu'ils sont soumis à une irradiation par le faisceau blanc synchrotron. Ainsi, en choisissant bien la nature des polymères constituant les films, on peut obtenir par irradiation un ensemble constitué d'une succession de films ayant des propriétés électriques différentes non seulement dans le sens horizontal, mais aussi dans le sens vertical.

D'autres caractéristiques et avantages de l'invention apparaîtront mieux à la lecture des exemples suivants donnés bien entendu à titre illustratif et non limitatif, en référence au dessin annexé sur lequel :

– la figure 1 représente de façon schématique une installation d'irradiation par le faisceau blanc du rayonnement synchrotron,

– la figure 2 est un diagramme représentant le spectre et le flux du faisceau blanc synchrotron utilisé dans les exemples,

– la figure 3 représente le spectre Auger réalisé sur un film de polyocthylthiophène après irradiation,

– la figure 4 représente le spectre Auger réalisé sur le même film de polyoctylthiophène que celui de la figure 3 avant irradiation,

– la figure 5 est le spectre IR d'un film de polyacrylonitrile, après irradiation pendant 15 minutes,

– la figure 6 est le spectre IR du film de polyacrylonitrile de la fig. 5 avant irradiation,

– la figure 7 représente la région 1200 à 1800 $cm^{-1}$ des spectres infrarouges de films de polyacrylonitrile avant et après irradiation, et

– la figure 8 représente les spectres de photoémission de films de polyacrylonitrile, avant et après irradiation.

<u>EXEMPLE 1</u> : Préparation et irradiation d'un film de polyoctylthiophène.

On dépose tout d'abord le film de polyoctylthiophène sur une électrode en platine par électropolymérisation. Dans ce but, on immerge l'électrode en platine dans une solution contenant 0,1 mole/l de perchlorate de lithium jouant le rôle de sel support et 0,1 mole/l d'octyl-3-thiophène dans de l'acétonitrile, et on applique à l'électrode de platine une polarisation anodique de +1,35 V par rapport à une électrode de référence au calomel saturé. On réalise cette électropolymérisation pendant une durée suffisante pour obtenir un film de poly-3-octyl-thiophène à l'état dopé conducteur, d'une épaisseur de 100 nm.

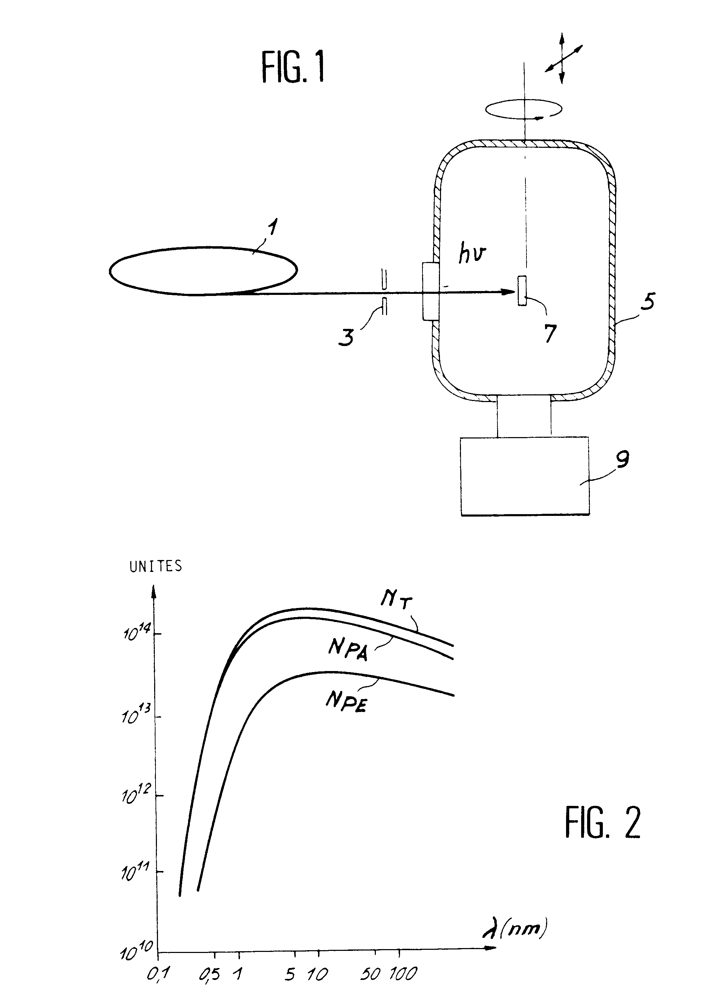

On soumet ensuite le film à une irradiation par le faisceau blanc du rayonnement synchrotron en utilisant l'installation représentée de façon très schématique sur la figure 1.

Sur cette figure, on voit que le rayonnement issu du synchrotron 1 est dirigé après passage dans une fente d'entrée 3 dans une chambre à vide 5 à l'intérieur de laquelle on dispose l'électrode 7 revêtue du film de polymère à irradier qui peut être déplacée verticalement et horizontalement dans le sens des flèches par des moyens appropriés, non représentés sur le dessin. On peut faire le vide dans la chambre 5 en utilisant le groupe de pompage 9.

Sur la figure 2, on a représenté le spectre et le flux du faisceau blanc sortant par la fente 3.

Sur cette figure, la courbe $N_T$ représente le flux total exprimé en nombre de photons par seconde/$10^{-5}$Gy en fonction de la longueur d'onde (en nm),
- la courbe $N_{PA}$ représente le flux du faisceau pour une polarisation parallèle au plan d'incidence,
- la courbe $N_{PE}$ représente le flux du faisceau pour une polarisation perpendiculaire au plan d'incidence.

Après irradiation pendant 1000 s, on examine la structure du film de polyoctylthiophène par spectroscopie Auger.

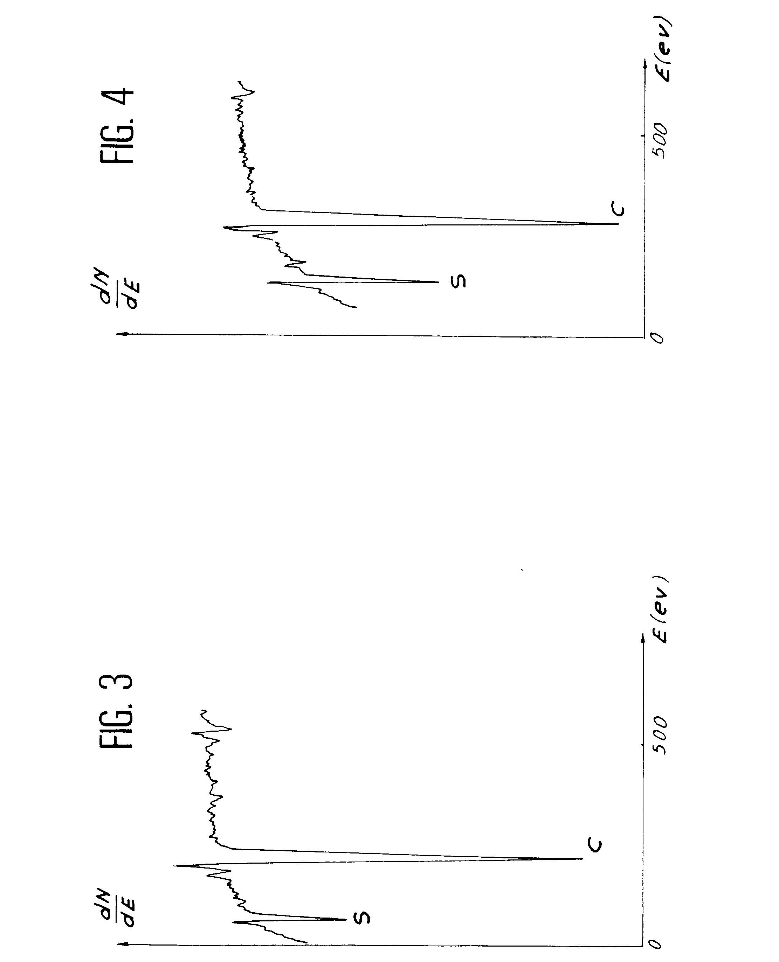

La figure 3 représente le spectre obtenu après irradiation, et la figure 4 donnée à titre comparatif illustre le spectre obtenu sur le film de polyoctylthiophène avant irradiation.

En comparant ces deux spectres, on remarque que la structure chimique du polymère évolue et que la quantité de soufre diminue.

Une mesure de la conductivité du film avant et après irradiation a donné les résultats suivants :
- conductivité avant irradiation : $1\Omega^{-1}cm^{-1}$
- conductivité après irradiation : $10^{-8}\Omega^{-1}cm^{-1}$

Ainsi, l'irradiation conduit à une diminution très importante de la conductivité électrique du polymère conducteur qui devient isolant.

EXEMPLE 2

On suit le même mode opératoire que dans l'Exemple 1 pour déposer sur une électrode de platine, un film de polyméthylthiophène de 100 nm d'épaisseur, puis on l'irradie pendant 1000 s au moyen du faisceau blanc synchrotron.

Les conductivités électriques du film avant et après irradiation sont les suivantes :
- conductivité avant irradiation : $10^2\Omega^{-1}cm^{-1}$
- conductivité après irradiation : $10^{-8}\Omega^{-1}cm^{-1}$

EXEMPLE 3

Dans cet exemple, on prépare un film de polyacrylonitrile sur un substrat en nickel par électropolymérisation sous polarisation cathodique.

Dans ce but, on immerge le substrat en nickel dans une solution électrolytique contenant $5.10^{-2}$ mol/l de perchlorate de tétraéthylammonium jouant le rôle de sel support, et 2,5 mol/l d'acrylonitrile dans de l'acétonitrile. On applique sur le substrat de nickel qui joue le rôle de cathode une polarisation de -2,4 V par rapport à une électrode Ag/Ag$^+$ pendant une durée de 2 secondes pour former sur le substrat un film de polyacrylonitrile ayant une épaisseur de 300 nm.

On soumet ensuite le film de polyacrylonitrile ainsi obtenu à une irradiation par le faisceau blanc du rayonnement synchrotron pendant 15 minutes dans l'installation représentée sur la figure 1.

Avant et après irradiation, on examine la structure du film de polyacrylonitrile par spectrométrie d'absorption infrarouge.

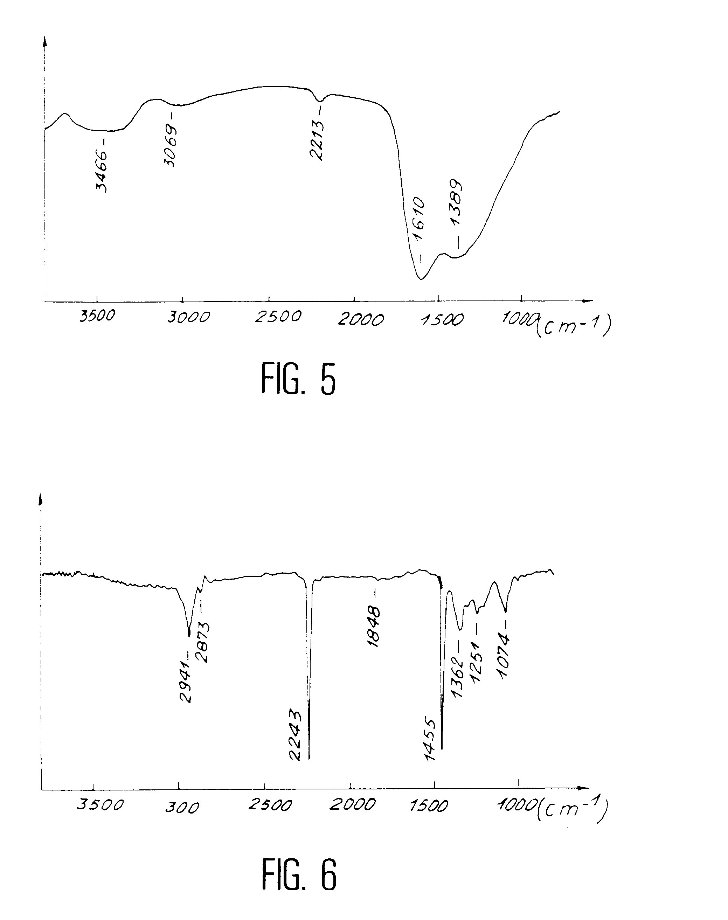

La figure 5 représente le spectre infrarouge obtenue après irradiation et la figure 6 représente le spectre infrarouge obtenu avant irradiation du film.

En comparant ces deux spectres, on constate une évolution considérable de la structure du polymère qui se traduit par la disparition complète des groupements nitrile caractéristiques du polymère (bande d'absorption à 2 243 cm$^{-1}$ sur le polymère d'origine) et par la formation d'une très forte densité de double liaisons car-bone/carbone (massif large et intense centré sur 1 610 cm$^{-1}$ sur la figure 5). Du point de vue de la structure électronique, cette évolution vers une forme moléculaire de type graphitique correspond au passage du cara-tère isolant du polymère de départ vers un caractère conducteur.

La conductivité électrique du polymère passe d'ailleurs de $10^{-13}$ohm$^{-1}$ cm$^{-1}$ pour le polyacrylonitrile non irradié à $10^3$ ohm$^{-1}$ cm$^{-1}$ pour le polymère irradié pendant 15 minutes.

EXEMPLE 4 :

Dans cet exemple, on prépare un film de polyacrylonitrile par dépôt au trempé sur un substrat en platine.

Dans ce but, on dissout du polyacrylonitrile ayant une masse moléculaire moyenne de 86000, dans du diméthylformamide, puis on dépose sur le substrat de platine une couche de la solution obtenue et on laisse évaporer le solvant, puis on sèche sous vide pour éliminer les traces de solvant. On obtient ainsi un film de polyacrylonitrile de 300 nm en utilisant une concentration en polyacrylonitrile de la solution de 3 % en poids/volume.

On soumet ensuite le film obtenu à une irradiation par le faisceau blanc du rayonnement synchrotron pendant 15 secondes.

Après cette irradiation, on examine le film par spectroscopie infrarouge.

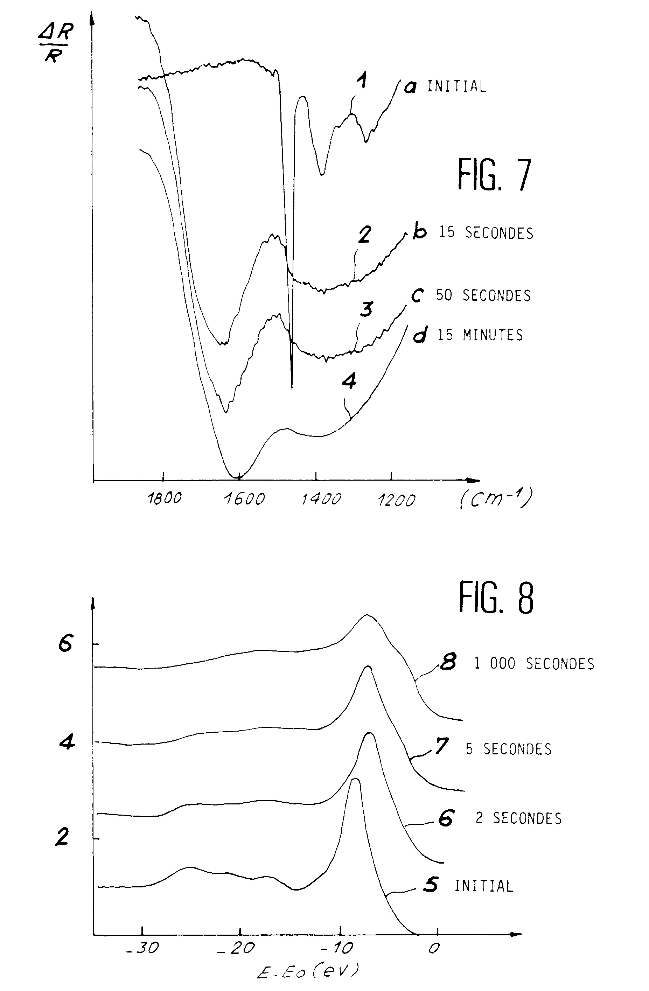

Sur la figure 7, on a représenté la région 1800-1200 $cm^{-1}$ du spectre obtenu après 15 secondes (courbe 2), la courbe 1 représentant le spectre obtenu avant irradiation du film.

EXEMPLE 5 :

On suit le même mode opératoire que dans l'exemple 4 mais on réalise l'irradiation pendant 50 secondes. On analyse ensuite la structure du film par spectroscopie infrarouge. La courbe 3 de la figure 7 représente le spectre obtenu.

EXEMPLE 6 :

On suit le même mode opératoire que dans l'exemple 4 pour préparer un film de polyacrylonitrile de 300 nm d'épaisseur, puis on soumet le film à une irradiation par le faisceau blanc du rayonnement synchrotron pendant 15 minutes.

Après irradiation, on examine la structure du film par spectroscopie infrarouge.

La courbe 4 de la figure 7 représente le spectre obtenu.

En comparant les courbes 1 à 4 de la figure 7, on remarque que la bande à 1640 $cm^{-1}$ qui correspond à une vibration C=C, se déplace vers une fréquence plus basse sous l'effet de l'irradiation et qu'elle se situe à 1610 $cm^{-1}$ après 15 minutes d'irradiation.

Ceci indique qu'une structure aromatique se développe au fur et à mesure que les groupes CN, CH et $CH_2$ disparaissent.

Ainsi, la structure chimique du film après 15 minutes d'irradiation est analogue à celle du graphite.

EXEMPLE 7 :

Dans cet exemple, on prépare un film de polyacrylonitrile de 300nm d'épaisseur par dépôt au trempé sur un substrat en platine comme dans l'Exemple 4 et on soumet ensuite le film obtenu à une irradiation par le faisceau blanc du rayonnement synchrotron pendant 2 secondes.

Après cette irradiation, on examine le film par spectroscopie de photo-émission.

Sur la figure 8, on a représenté le spectre obtenu après ces 2 secondes (courbe 6), la courbe 5 représentant le spectre obtenu avant irradiation du film.

EXEMPLE 8 :

On suit le même mode opératoire que dans l'Exemple 7, mais on réalise l'irradiation pendant 5 secondes. On analyse ensuite la structure du film par spectroscopie de photo-émission. La courbe 7 de la figure 8 représente le spectre obtenu.

EXEMPLE 9 :

On suit le même mode opératoire que dans l'Exemple 7 pour préparer un film de polyacrylonitrile de 300nm d'épaisseur, puis on soumet le film à une irradiation par le faisceau blanc du rayonnement synchrotron pendant 1000 secondes.

Après irradiation, on examine la structure du film par spectroscopie de photo-émission.

La courbe 8 de la figure 8 représente le spectre obtenu.

En comparant les courbes 5 à 8 de la figure 8, on remarque que la structure de la bande de valence du polymère évolue. Ainsi après 2 secondes d'irradiation, l'ensemble du spectre se déplace en énergie, ce qui traduit une disparition du phénomène de charge électrique due au caractère isolant du polymère initial, alors que l'on observe un peuplement de la bande interdite. Pour les temps d'irradiation supérieurs de 5 et 1000 secondes (courbes 7 et 8) aucun phénomène de charge ne se manifeste, alors que le peuplement de la bande interdite s'intensifie traduisant l'évolution vers un caractère conducteur pour le polymère.

Des mesures de conductivité électrique effectuées sur les films des exemples 7 à 9 sont données dans le tableau annexé. Dans ce tableau, on a également donné la conductivité électrique du film de polyacrylonitrile avant irradiation.

Au vu de ce tableau, on constate que la conductivité électrique du polymère augmente continuellement avec la durée d'irradiation.

Ainsi le procédé de l'invention permet un contrôle de la conductivité électrique du polymère en jouant sur le temps d'irradiation.

A ce sujet, on a aussi constaté qu'en effectuant l'irradiation pendant la même durée, mais en plusieurs fois, on obtenait le même résultat.

## TABLEAU

| Polyacrylonitrile (film de 300nm) | Conductivité électrique |
|---|---|
| avant irradiation | $10^{-13} \Omega^{-1}$ $cm^{-1}$ |
| après 2s d'irradiation (ex. 7) | $10^{-2} - 10^{-4} \Omega^{-1}$ $cm^{-1}$ |
| après 5s d'irradiation (ex. 8) | $10^{2} - 2.10^{2} \Omega^{-1} cm^{-1}$ |
| après 1000s d'irradiation (ex. 9) | $10^{3} - 3.10^{3} \Omega^{-1}$ $cm^{-1}$ |

## Revendications

1. Procédé pour modifier les propriétés de conductivité électrique d'un polymère organique, caractérisé en ce qu'il consiste à irradier au moins certaines parties d'un film de ce polymère par le faisceau blanc du rayonnement synchrotron.

2. Procédé selon la revendication 1, caractérisé en ce que l'épaisseur du film est de 1nm à 50μm.

3. Procédé selon l'une quelconque des revendications 1 et 2, caractérisé en ce que le film de polymère est préparé par électropolymérisation.

4. Procédé selon l'une quelconque des revendications 1 à 3, caractérisé en ce que le polymère de départ est conducteur de l'électricité et en ce que l'on diminue sa conductivité électrique par irradiation au moyen du faisceau blanc du rayonnement synchrotron.

5. Procédé selon la revendication 4, caractérisé en ce que le polymère est un polyalkylthiophène.

6. Procédé selon l'une quelconque des revendications 1 à 3, caractérisé en ce que le polymère de départ est isolant et en ce que l'on augmente sa conductivité électrique par irradiation au moyen du faisceau blanc du rayonnement synchrotron.

7. Procédé selon la revendication 6, caractérisé en ce que le polymère isolant est un polymère à groupes pendants choisis parmi les groupes nitrile, ester, aldéhyde et pyridine.

8. Procédé selon la revendication 7, caractérisé en ce que le polymère est le polyacrylonitrile.

9. Procédé selon l'une quelconque des revendications 1 à 8, caractérisé en ce que l'on règle l'augmentation ou la diminution de conductivité électrique du polymère en contrôlant le temps d'irradiation.

10. Procédé selon l'une quelconque des revendications 1 à 3, caractérisé en ce que l'on soumet à l'irradiation un ensemble constitué de plusieurs films de polymère superposés.

11. Procédé selon la revendication 10, caractérisé en ce qu'au moins deux films de l'ensemble sont réalisés en des polymères ayant un comportement différent lorsqu'ils sont soumis à une irradiation par le faisceau blanc du rayonnement synchrotron.

FIG. 1

FIG. 2

8

## FIG. 3

$\frac{dN}{dE}$

S

C

$0$     $500$     $E\,(ev)$

## FIG. 4

$\frac{dN}{dE}$

S

C

$0$     $500$     $E(ev)$

EP 0 500 414 A1

FIG. 5

FIG. 6

FIG. 7

a INITIAL
b 15 SECONDES
c 50 SECONDES
d 15 MINUTES

FIG. 8

8 1 000 SECONDES
7 5 SECONDES
6 2 SECONDES
5 INITIAL

EP 0 500 414 A1

Office européen des brevets

**RAPPORT DE RECHERCHE EUROPEENNE**

Numero de la demande

EP 92 40 0337

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | FR-A-2 552 094 (ROHM)<br>* Page 7, ligne 37 - page 8, ligne 5 *<br>--- | 1-11 | B 29 C 71/04<br>B 29 C 59/16 |
| A | US-A-4 028 547 (EISENBERGER)<br>* Colonne 3, lignes 9-42; revendication 1 *<br>--- | 1-11 | |
| D,A | WO-A-8 802 692 (COMMISSARIAT A L'ENERGIE ATOMIQUE)<br>* Page 2, lignes 17-24; page 3, lignes 16-27; page 7, ligne 18 *<br>--- | 1-11 | |
| A | US-A-4 491 605 (MAZUREK et al.)<br>* Colonne 2, ligne 8 *<br>--- | 5 | |
| A | PATENT ABSTRACTS OF JAPAN, vol. 8, no. 199 (C-242)[1636], 12 septembre 1984; & JP-A-59 091 129 (TOYODA CHUO KENKYUSHO) 25-05-1984<br>--- | 8 | |
| A | SPIE, vol. 1022, Laser Assisted Processing, 1988, pages 112-117; C. DECKER: "Direct writing of microcircuits by laser-assisted processing of polymers"<br>* Page 116 *<br>----- | 1-11 | DOMAINES TECHNIQUES RECHERCHES (Int. Cl.5)<br><br>B 29 C<br>H 01 B<br>B 01 J<br>C 08 J |

Le présent rapport a été établi pour toutes les revendications

| Lieu de la recherche | Date d'achèvement de la recherche | Examinateur |
|---|---|---|
| LA HAYE | 20-05-1992 | ATTALLA G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
......................................
& : membre de la même famille, document correspondant

EPO FORM 1503 03.82 (P0402)

12